(19) Europäisches Patentamt
European Patent Office
Office européen des brevets

(11) **EP 2 995 916 B1**

(12) **EUROPEAN PATENT SPECIFICATION**

(45) Date of publication and mention
of the grant of the patent:
**26.07.2023 Bulletin 2023/30**

(21) Application number: **15183849.7**

(22) Date of filing: **04.09.2015**

(51) International Patent Classification (IPC):
**G01J 5/02** (2022.01)        **G01J 5/10** (2006.01)
**G01J 5/20** (2006.01)        **G01J 5/08** (2022.01)

(52) Cooperative Patent Classification (CPC):
**G01J 5/024; G01J 5/0808; G01J 5/0853;
G01J 5/10; G01J 5/12; G01J 5/20**

(54) **SURFACE MICRO-MACHINED INFRARED SENSOR USING HIGHLY TEMPERATURE STABLE INTERFEROMETRIC ABSORBER**

OBERFLÄCHEN-MIKROBEARBEITETER INFRAROTSENSOR UNTER VERWENDUNG EINES HOCH TEMPERATURSTABILEN INTERFEROMETRISCHEN ABSORBERS

CAPTEUR INFRAROUGE À SURFACE MICRO-USINÉE UTILISANT UN ABSORBEUR INTERFÉROMÉTRIQUE STABLE À TEMPÉRATURE ÉLEVÉE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **12.09.2014 US 201414484856**

(43) Date of publication of application:
**16.03.2016 Bulletin 2016/11**

(73) Proprietor: **Excelitas Technologies Singapore Pte Ltd.**
**Singapore 627969 (SG)**

(72) Inventors:
• **KROPELNICKI, Piotr**
**79100 Nusajaya (MY)**
• **MARINESCU, Radu**
**Pointe-Claire, Québec H9R 3C3 (CA)**
• **KARAGOEZOGLU, Hermann**
**65205 Wiesbaden (DE)**
• **CHUAN, Kai Liang**
**670506 Singapore (SG)**

(74) Representative: **Hancox, Jonathan Christopher**
**Venner Shipley LLP**
**Windsor House**
**6-10 Mount Ephraim Road**
**Tunbridge Wells, Kent TN1 1EE (GB)**

(56) References cited:
**WO-A2-2008/003080        US-A1- 2009 140 148
US-A1- 2010 031 992**

• **BASU S ET AL: "Infrared radiative properties of heavily doped silicon at room temperature", ASME INTERNATIONAL MECHANICAL ENGINEERING CONGRESS AND EXPOSITION, PROCEEDINGS (ASME INTERNATIONAL MECHANICAL ENGINEERING CONGRESS AND EXPOSITION, IMECE 2007,, vol. 8, no. Part B, 1 January 2008 (2008-01-01), pages 1241-1253, XP009139765,**

**Description**

FIELD OF THE INVENTION

The present invention relates to radiation sensors, and more particularly, is related to infrared radiation sensors.

BACKGROUND OF THE INVENTION

Thermopile infrared sensors are well known to possess temperature stability, for example of up to about 300° C, and low power consumption, for example, a U electronic 32x32 microbolometer array with 450 mW power consumption, or an Excelitas 32x32 array with less than 200 mW power consumption. However, since the detectivity of these sensors is known to be low, compared to a conventional resistive microbolometer (a-Si, VOx, herein referred to as "microbolometer"), approaches have been made to compensate this issue by increasing the pixel size. Such sensors with increased pixel sizes include, for example, a sensor having detectivity of $10^8$ cmHz$^{1/2}$/W and a microbolometer having detectivity of $10^9$ cmHz$^{1/2}$/W, as well as a thermopile infrared (IR) sensor size of greater than 1 mm $\times$ 1 mm, compared to a microbolometer of 25 $\mu$m $\times$ 25 $\mu$m. Therefore, the etching a cavity in the back side of a substrate below the sensor ("back side etch") coupled with a front side undercut release process and a bulky absorber on the frontside of the sensor have been incorporated to build sensors, which may be operated without a vacuum.

With the development of new complementary metal-oxide-semiconductor (CMOS) process technology, as known from microbolometer sensors, further miniaturization of the thermopile sensor can be reached by using front-side gas release processes. For example, using XeF$_2$ or Vapor HF, an interferometric absorber, and/or thin film deposition and chip-scale or wafer-level packaging techniques, allows the sensor to reach equivalent microbolometer detectivity capabilities for a relatively low cost price.

Nevertheless, thermopile sensors generally demand high temperature annealing processes in order to activate the dopants of the n-type and p-type silicon, making CMOS readout circuit and common interferometric absorber integration where metal such as aluminum (Al) is used as reflector, impossible.

The sensor of some traditional thermopile sensors may be released from the front-side. However, with these traditional thermopiles, a bulky absorber needs to be implemented, due to the under-etch of the silicon beneath the sensor. Additionally, the lateral etch control is generally imprecise, making an integration of sensors as an array almost impossible.

Therefore, there is a need in the industry to overcome one or more of the abovementioned shortcomings.

US2010/0031992A1 discloses a thermopile sensor.

SUMMARY OF THE INVENTION

The invention provides a method for manufacturing a surface machined thermopile infrared sensor package in accordance with claim 1 and a surface machined thermopile infrared sensor in accordance with claim 6. Additional features of the invention are defined in the dependent claims.

Other systems, methods and features of the present invention will be or become apparent to one having ordinary skill in the art upon examining the following drawings and detailed description.

BRIEF DESCRIPTION OF THE DRAWINGS

The accompanying drawings are included to provide a further understanding of the invention, and are incorporated in and constitute a part of this specification. The components in the drawings are not necessarily to scale, emphasis instead being placed upon clearly illustrating the principles of the present invention. The first embodiment is in accordance with the claimed invention. The second to fifth embodiments are not in accordance with the claimed invention but are present for illustration purposes only.

FIG. 1A is a cross sectional schematic diagram showing a first stage of manufacture of a thermopile under the first embodiment.

FIG. 1B is a cross sectional schematic diagram showing a second stage of thermopile manufacture.

FIG. 1C is a cross sectional schematic diagram showing a third stage of thermopile manufacture.

FIG. 1D is a cross sectional schematic diagram showing a fourth stage of thermopile manufacture.

FIG. 1E is a cross sectional schematic diagram showing a fifth stage of thermopile manufacture.

FIG. 1F is a cross sectional schematic diagram showing a sixth stage of thermopile manufacture.

FIG. 2 is a flowchart of a method for manufacturing the thermopile device of FIGS. 1A-1F.

FIG. 3 is a cross sectional schematic diagram showing thermopile manufacture indicating the spacing between the absorber and the reflector.

FIG. 4A is a cross sectional schematic diagram showing a first stage of manufacture of a diode-bolometer under the second embodiment.

FIG. 4B is a cross sectional schematic diagram showing a second stage of diode-bolometer manufacture.

FIG. 4C is a cross sectional schematic diagram showing a third stage of diode-bolometer manufacture.

FIG. 4D is a cross sectional schematic diagram showing a fourth stage of diode-bolometer manufacture.

FIG. 4E is a cross sectional schematic diagram showing a fifth stage of diode-bolometer manufacture.

FIG. 4F is a cross sectional schematic diagram showing a sixth stage of diode-bolometer manufacture.

FIG. 5 is a flowchart of a method for manufacturing the diode-bolometer device of FIGS. 4A-4F.

FIG. 6A is a cross sectional schematic diagram of a thermopile under the first embodiment.

FIG. 6B is a top view schematic diagram of the thermopile under the first embodiment.

FIG. 7A is a cross sectional schematic diagram of a lateral diode-bolometer under the second embodiment.

FIG. 7B is a top view schematic diagram of the lateral diode-bolometer under the second embodiment.

FIG. 8A is a cross sectional schematic diagram of a vertical diode-bolometer under the third embodiment.

FIG. 8B is a top view schematic diagram of the vertical diode-bolometer under the third embodiment.

FIG. 9A is a cross sectional schematic diagram of a resistive microbolometer under the fourth embodiment.

FIG. 9B is a top view schematic diagram of the resistive microbolometer under the fourth embodiment.

FIG. 10 is a cross sectional schematic diagram of a vacuum package embodiment of a thermopile.

FIG. 11 is a top view schematic diagram of an array integration of resistive microbolometers of FIGS. 9A-9B under a fifth embodiment.

DETAILED DESCRIPTION

The following definitions are useful for interpreting terms applied to features of the embodiments disclosed herein, and are meant only to define elements within the disclosure. No limitations on terms used within the claims are intended, or should be derived, thereby. Terms used within the appended claims should only be limited by their customary meaning within the applicable arts.

As used within this disclosure, "substantially" means "very nearly," for example, "substantially uniform" means uniform within normal manufacturing tolerances as would be expected by persons having ordinary skill in the art.

As used within this disclosure, "thin" means less than about 15 nm for TiN, or less than about 15 nm for NiCr, and less than about 200 nm for doped silicon.

As used within this disclosure, a thin film interferometric absorber refers to an interferometric absorber having a thin film formed of a material having a sheet resistance on the order of 377 $\Omega$/sq. For example, the material may be TiN, NiCr, doped silicon, or any other material with a sheet resistance of approximately 377 $\Omega$/sq.

As used within this disclosure, a thin film thermopile/diode-bolometer/resistive microbolometer refers to a sensor membrane which is generally thinner than 2 $\mu$m including a sensing material and an absorber layer.

As used within this disclosure, "temperature stable" refers to stability of a material at temperatures of up to around 1100° C.

As used within this disclosure, "increased detectivity" generally refers to a detectivity improvement over a benchmark of $5 \times 10^8$ cmHz$^{1/2}$/W for approximately 1 mm $\times$ 1 mm pixel size. For example, a $5 \times 10^8$ cmHz$^{1/2}$/W for a 65 $\mu$m $\times$ 65 $\mu$m pixel size would have area on the order of 200 times less than the 1 mm $\times$ 1 mm pixel, while providing similar response. Therefore, increased detectivity indicates an improvement of detectivity of up to fifteen times or more.

As used within this disclosure, highly doped silicon refers to a peak doping concentration after annealing of greater than $10^{20}$/cm$^3$.

Reference will now be made in detail to embodiments of the present invention, examples of which are illustrated in the accompanying drawings. Wherever possible, the same reference numbers are used in the drawings and the description to refer to the same or like parts.

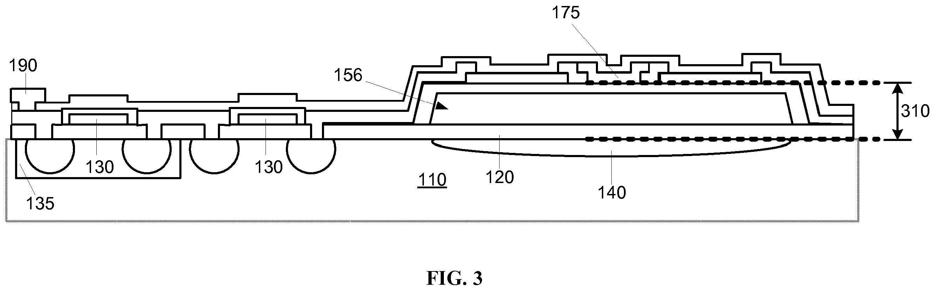

Exemplary embodiments of the present invention implement a novel, high temperature stable interferometric absorber and an aligned process to incorporate one or more CMOS devices, a thermopile IR sensor, and on-wafer vacuum packaging together. Embodiments include a surface micro machined thermopile sensor having an interferometric absorber based on a highly doped silicon reflector (on a silicon bulk wafer) and an impedance matched, IR absorbing layer, for example, a 7 nm Ti-N approximately 377 Ohm/sq, on the sensor, which are separated by one quarter wavelength distance 310 (FIG. 3) from each other, in order to adjust the absorption for the desired wavelength. For example, the far infrared range (FIR) has a wavelength range of approximately 8 $\mu$m-14 $\mu$m, therefore an optical distance of approximately 2.5 $\mu$m may be used, representing a center quarter wavelength of absorption of 10 $\mu$m.

Embodiments include a process for constructing a thermopile IR sensor / diode-bolometer, which enable drastic miniaturization and a detectivity boost. By replacing a traditional microbolometer interferometric absorber which uses metal as reflector, with a highly doped silicon reflector, the thermopile IR sensor can be highly optimized and have similar process freedom as a low temperature processed microbolometer.

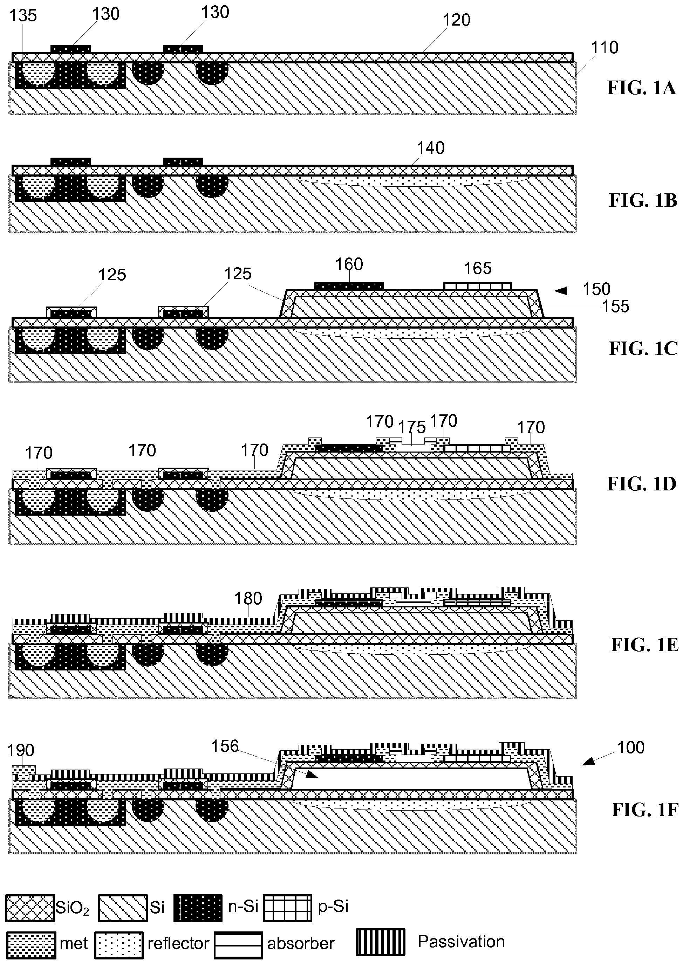

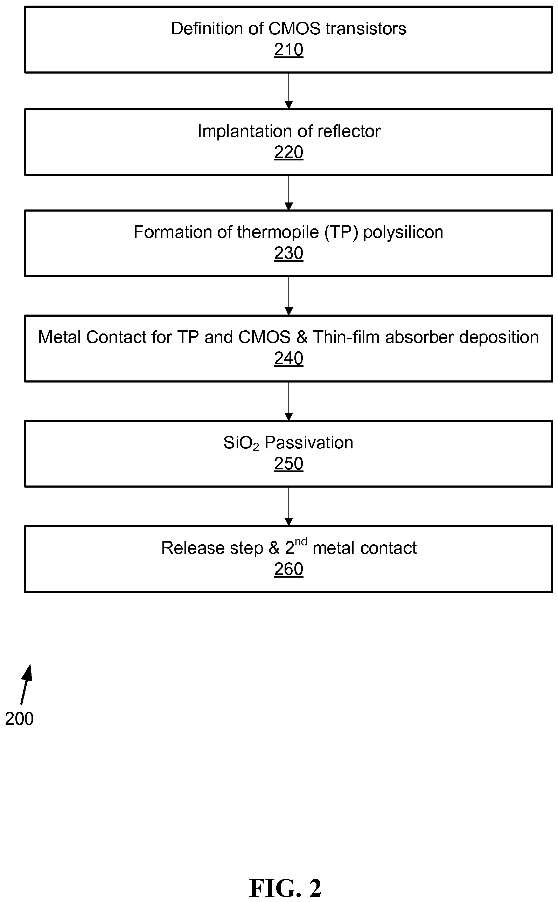

FIG. 2 is a flowchart of a first embodiment for producing a thermopile IR sensor. Steps of the process 200 are illustrated in FIGS. 1A-1F. It should be noted that any process descriptions or blocks in flowcharts should be understood as representing modules, segments, portions of code, or steps that include one or more instructions for implementing specific logical functions in the process, and alternative implementations are included within the scope of the present invention in which functions may be executed out of order from that shown or discussed, including substantially concurrently or in reverse order, depending on the functionality involved, as would be understood by those reasonably skilled in the art of the present invention.

As shown by block 210 and FIG. 1A, CMOS transistors 130 and a CMOS circuit 135 are fashioned on a silicon substrate 110 prepared with a first silicon dioxide layer 120. Alternatively, other semiconducting material known in CMOS processing may be used to fashion the substrate 110, for example, Germanium. A thin reflector 140 formed of highly doped silicon is implanted in the substrate 110 beneath the silicon dioxide layer 120, as shown by block 220 and FIG. 1B, for example, using ion implantation or diffusion. As shown by block 230 and FIG. 1C, a polysilicon thermopile 150 is formed above the reflector 140, including a silicon spacer 155, overlaid with a second silicon dioxide layer 125. A wafer of n-type sensing silicon 160 and a wafer of p-type sensing silicon 165 are formed above the second silicon dioxide layer 125 above the silicon spacer 155. The thickness of the silicon spacer 155 may be determined according to the desired detected wavelength, as described below.

As shown by block 240 and FIG. 1D, metal contacts 170 for the thermopile 150, and CMOS transistors 130 are deposited, along with a thin film absorber 175 between the wafer of n-type sensing silicon 160 and the wafer of p-type sensing silicon 165. The absorber may be formed of, for example, TiN or NiCr or doped silicon, among other CMOS compatible materials that can reach 377 $\Omega$/sq. The absorber 175 can absorb greater than 85 percent of the incident IR-light in a wavelength of 8-14

$\mu$m, by choosing an appropriate doping concentration and energy for the reflector 140. The reflector may cover a wavelength range of 8$\mu$m-14$\mu$m with a peak doping concentration after annealing of greater than $10^{20}$ /cm$^3$. For example, the doping energy may be 70 KeV for boron Ion implantation or 160 KeV for phosphorous Ion implantation. As described below, the absorber 175 serves as an electrical connector between the wafer of n-type sensing silicon 160 and the wafer of p-type sensing silicon 165.

As shown by block 250 and FIG. 1E, a passivation layer 180 is applied. The passivation layer 180 material may be, for example, SiO$_2$, which is selective to the release step gas, as described below. As shown by block 240 and FIG. 1D. As shown by block 260 and FIG. 1F, a release step is performed to release the thermopile membrane 150, and a second metal contact 190 is formed. For the release of the membrane 150, the silicon spacer 155 is etched using a highly selective gas, for example, Xenondifluoride XeF$_2$, etching only the silicon and not attacking the SiO$_2$, for example, the second silicon dioxide layer 125 and the passivation layer 180 surrounding and protecting the thermopile sensing elements 160,165. This suspends and thermally isolates the membrane 150 over a cavity 156 above the silicon substrate 110 wafer. Since no backside release or under-etching of silicon is necessary, very controlled gas release processes can be replied, for example, as per XeF$_2$ or Vapor HF microbolometers.

The reflective behavior of highly doped silicon can be described by a free electron model derived from the Drude model. Herein, free electrons determine the plasma frequency, which leads to reflection of electromagnetic waves having frequencies lower than the plasma frequency:

$$\omega_p = \sqrt{\frac{ne^2}{\epsilon_0 m}} \quad \text{(Eq. 1)}$$

where $\omega_p$ is the plasma frequency, n is the amount of free electrons, e is elementary charge, m is the mass of the electron and $\varepsilon_0$ is the dielectric constant. In order to reach lower wavelengths, the higher the free electron concentration (doping concentration in silicon), the higher the plasma frequency becomes, for example, far infrared.

The reflector 140 is therefore highly temperature stable and able to survive a dopant activation step of the thermopile sensing materials 160, 165. Due to the miniaturized structure, front-side gas release steps, as mentioned above, can be used and therefore eliminate undercut release steps of traditional thermopiles, preventing loss of pixel area and enabling focal plane array (FPA) integration.

By decreasing the bulk of the IR absorber when compared to traditional thermopiles, the thickness of the doped sensing material 160, 165 can be minimized, which in turn decreases the thermal conductivity $\lambda_{th}$ and the thermal capacity $C_{th}$ of the sensor 100, in order to keep the thermal time constant $\tau_{th}$ in the optimal value. This provides a significant advantage in terms of sensitivity over traditional sensors.

With the decrease of the thickness of the sensing material over traditional thermopiles, for example, but not limited to, a thickness below 200 nm, the Seebeck coefficient may significantly increase and the thermal conductivity may decrease (as known from silicon nanowires) and therefore enhance the sensitivity. For example, decreasing the thickness of the sensing material from 300 nm to 150 nm will increase the detectivity by around two times. The relationship of thickness to detectivity is an approximately linear. A decrease in thickness from 300 nm to 50 nm will implement a detectivity increase of nearly 6 times.

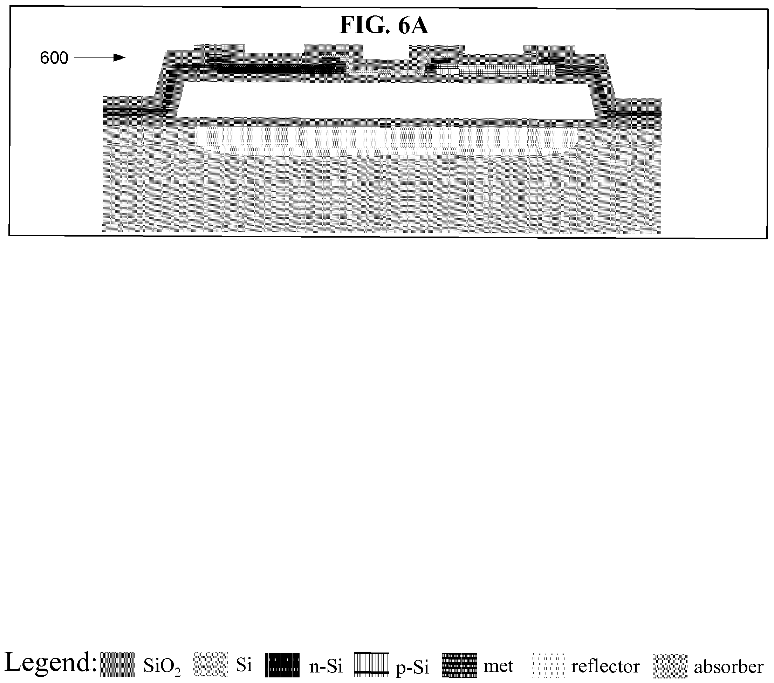

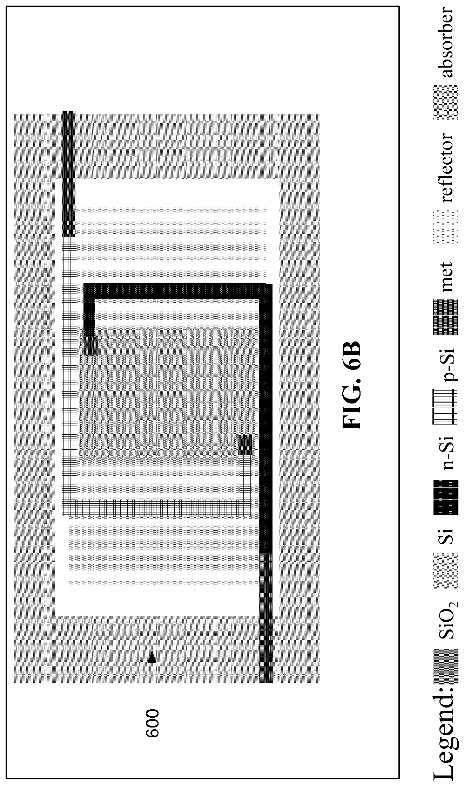

FIG. 6A is a cross sectional schematic diagram of a thermopile 600 under the first embodiment. FIG. 6B is a top view schematic diagram of an exemplary layout of the thermopile 600 under the first embodiment.

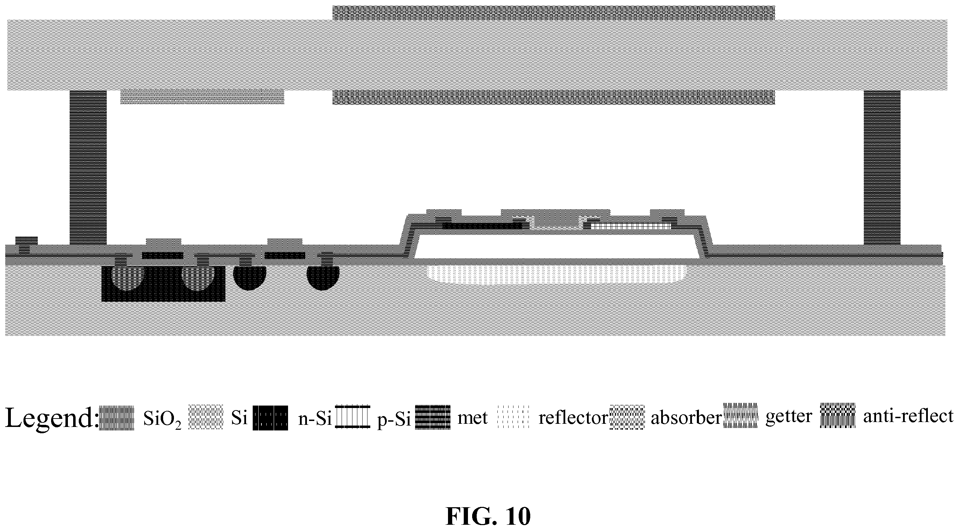

The surface micro machined thermopile sensor process 200 is suitable for the concurrent integration of CMOS circuitry and on-wafer vacuum packaging and can be applied to diode-bolometers, and/or novel resistive microbolometers such as polycrystalline microbolometers or other semi conductive sensing materials in the same manner, which require high temperature processes after forming the reflector. As shown by FIG. 10, the vacuum packaging removes the gases (air) around the sensors after the membrane release, as shown by block 260 (FIG. 2), so the heat created on the sensor membrane due to the IR-light absorption may not be transferred from the sensor 150 to the substrate 110 through gas convection, leading to a serious detectivity decrease, since it is desirable to heat-up the sensor 150 as much as possible to detect any signal change. By having vacuum around the sensor, the heat can only dissipate through the sensor arms, which is far more effective than having the gas convection effect.

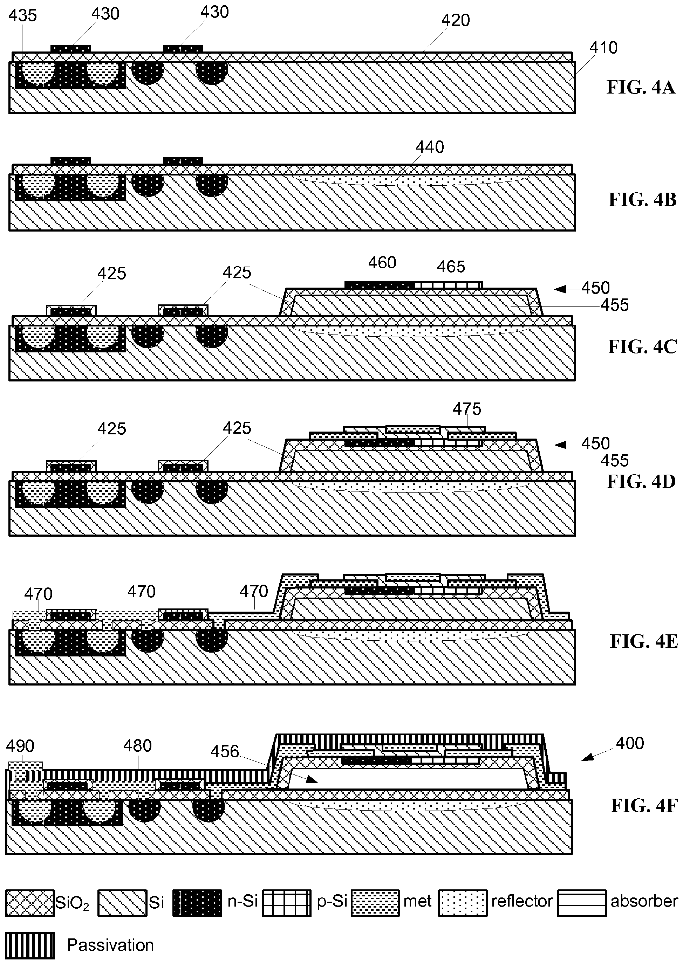

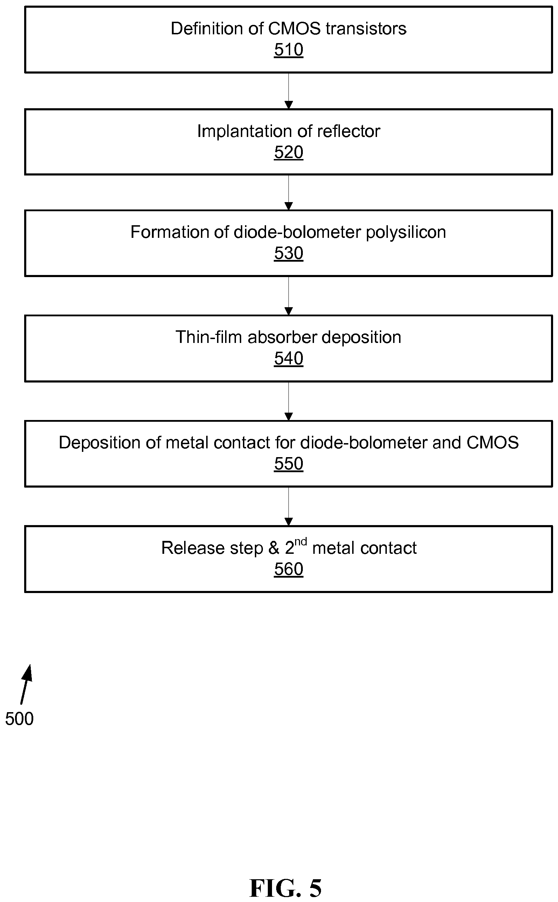

FIG. 5 is a flowchart of a second embodiment for producing a lateral diode-bolometer sensor. Steps of the process 500 are illustrated in FIGS. 4A-4F. As shown by block 510 and FIG. 4A, CMOS transistors 430 and a CMOS circuit 435 are fashioned on a silicon substrate 410 prepared with a first silicon dioxide layer 420. A thin reflector 440 formed of highly doped silicon is implanted in the substrate 410 beneath the silicon dioxide layer 420, as shown by block 520 and FIG. 4B, for example, using ion implantation or diffusion. As shown by block 530 and FIG. 4C, a polysilicon diode-bolometer 450 is formed above the reflector 440, including a silicon spacer 455, overlaid with a second silicon dioxide layer 425. A wafer of n-type sensing silicon 460 and a wafer of p-type sensing silicon 465 are formed above the second silicon dioxide layer 425 above the silicon spacer 455. The thickness of the silicon spacer 455 may be determined according to the desired detected wavelength, as described below.

As shown by block 540 and FIG. 4D, a thin film absorber 475 is deposited above the reflector 440.. As shown by block 550 and FIG. 4E, metal contacts 470 for the diode-bolometer 450, and CMOS transistors 430 are deposited. The absorber 475 may absorb greater than 85 percent of the incident IR-light in a wavelength of 8-14 $\mu$m with an appropriate choice of doping concentration and energy for the reflector 440. As described below, the absorber 475 serves as an electrical connector between the wafer of n-type sensing silicon 460 and the wafer of p-type sensing silicon 465. As shown by block 560 and FIG. 4F, a passivation layer 480 is applied, a release step is performed to remove the spacer 455 and forming a cavity 456, and a second metal contact 490 is formed. The release step may be performed substantially similarly as described above regarding the first embodiment.

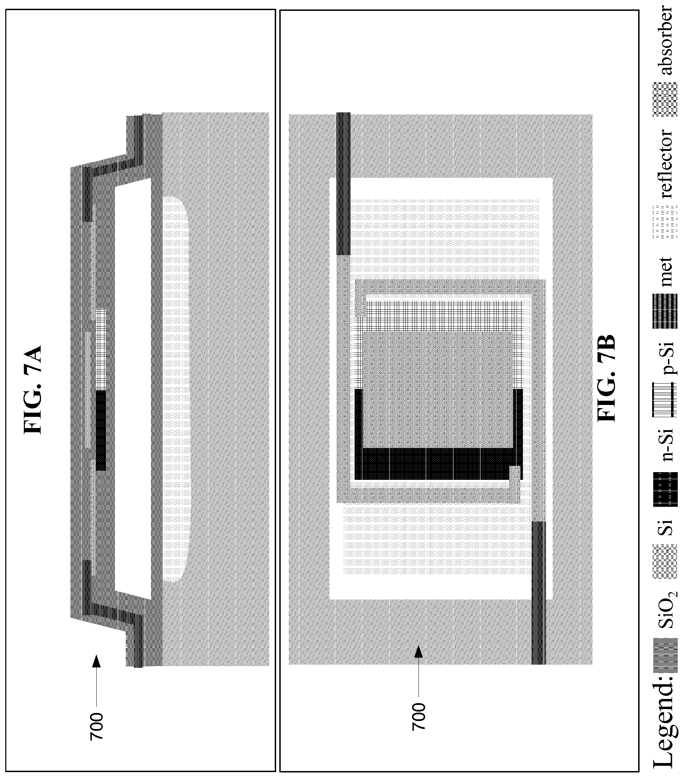

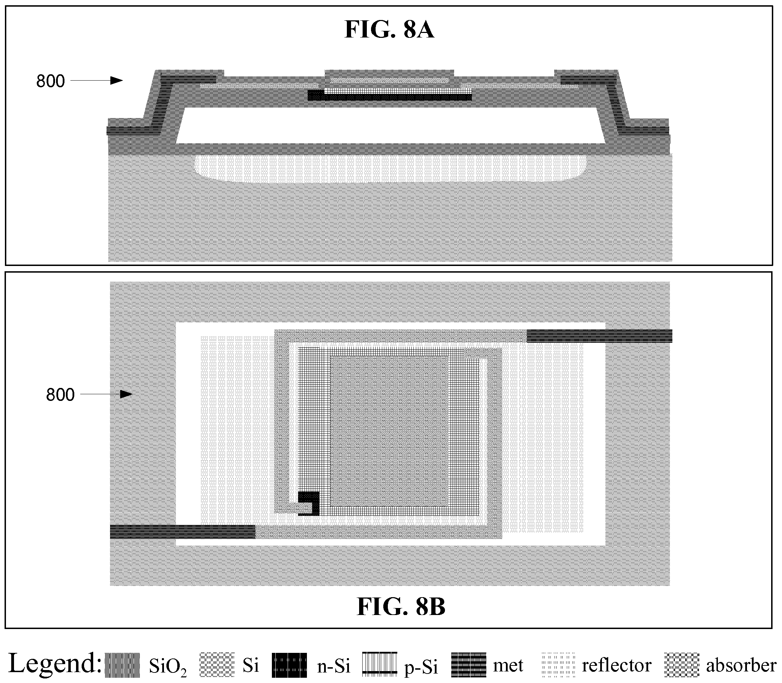

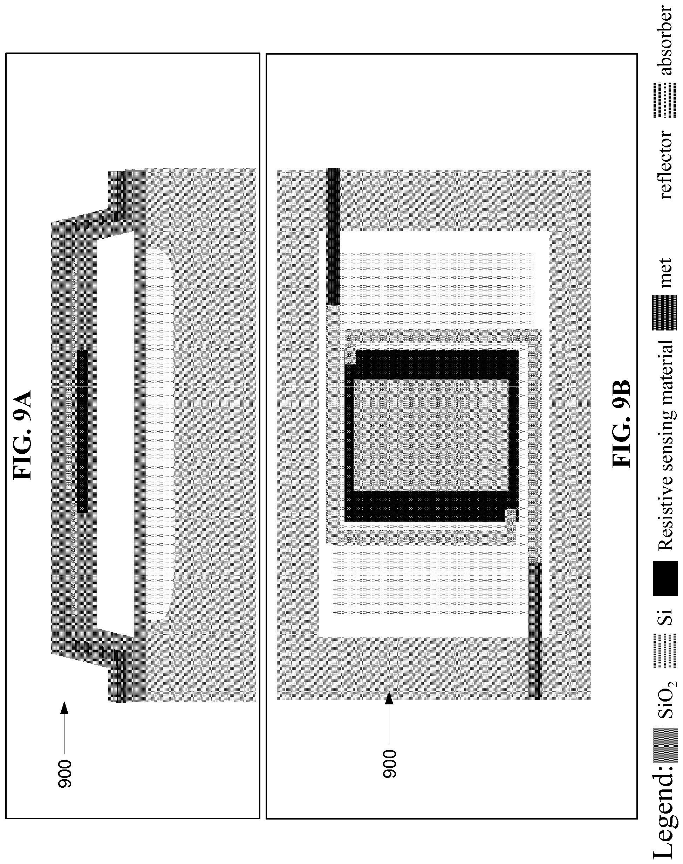

FIG. 7A is a cross sectional schematic diagram of a lateral diode-bolometer 700 under the second embodiment. FIG. 7B is a top view schematic diagram of the lateral diode-bolometer 700 under the second embodiment. Persons having ordinary skill in the art will recognize that other variations of the exemplary second embodiment device and method are possible. FIG. 8A is a cross sectional schematic diagram of a vertical diode-bolometer 800 under a third embodiment, and FIG. 8B is a top view schematic diagram of the vertical diode-bolometer 800 under the third embodiment. Similarly, FIG. 9A is a cross sectional schematic diagram of a resistive microbolometer 900 under a fourth embodiment, while FIG. 9B is a top view schematic diagram of the resistive microbolometer 900 under the fourth embodiment.

The abovementioned embodiments solve the problem of a bulky absorber and large area pixel(s) for thermopile/diode-bolometer infrared sensors and enable drastic miniaturization. By using a highly doped silicon reflector 140 for an interferometric absorber, high temperature processes to fabricate the thermopile sensor 100 can follow without destroying the reflector 140. CMOS circuitry and on-wafer vacuum packaging techniques can be well integrated within the thermopile IR sensor process 200 using this novel approach of the doped silicon reflector 140. At the same time, the absorber 175 may be used as an electrical connection between the n-type silicon 160 and the p-type sensing silicon 165, thereby increasing the absorption area, since no metal is necessary for the connection. The release step of such a surface micromachined structure may be done directly before chip scale packaging, therefore decreasing the possibility of damaged sensors due to handling. The same idea can be applied to production of a diode-bolometer and/or a resistive microbolometer, in order to avoid complex wafer bonding techniques and allow high temperature processes after creating the reflector.

An objective of the above embodiments is to achieve a new way of constructing a thermopile IR sensor / diode-bolometer, which enables drastic miniaturization and sensitivity boost. For example, compared with a detectivity of $5 \times 10^8$ cmHz$^{1/2}$/W for approximately a 1 mm × 1 mm pixel size for a traditional thermopile IR sensor / diode-bolometer, under the first embodiment detectivity may be approximately $5 \times 10^8$ cmHz$^{1/2}$/W for a 65 μm × 65 μm pixel size, corresponding to a decrease in area of about 200 times less, with a detectivity increase of greater than 15 times. In general, detectors under the first embodiment having significantly less area may provide a similar detectivity response. With the replacement of the traditional microbolometer interferometric absorber, which uses metal as reflector, by a highly doped silicon reflector, the thermopile IR sensor can be highly optimized and provide similar process freedom of a low temperature processed microbolometer. Therefore the performance of this sensor may be considered to be almost equivalent to a conventional microbolometer, having low power consumption and high temperature stability.

Traditional thermopile IR sensors, as mentioned above, use a bulky absorber and back side release processes, which can be eliminated by the first embodiment. Additionally, complex wafer bonding processes for the diode bolometer can be eliminated. New types of novel resistive microbolometers can be created, for example, a polycrystalline microbolometer, due to high temperature stability of the absorber.

The above embodiments are based on an interferometric absorber made of a highly doped silicon reflector coupled to a thin absorber (TiN, NiCr) within the thermopile/bolometer structure, wherein the distance of both layers should have an optical length of a quarter wavelength. For example, the thin absorber of the first embodiment may be on the order of 7 nm for TiN or less than 200 nm for doped silicon, compared with a traditional absorber, which may be on the order of 3.5 μm thick.

The absorber itself has a sheet-resistance on the order of approximately 200 Ω/sq - 1000 Ω/sq, preferably 377Ω/sq, in order to match the atmospheric impedance. Therefore, reflection on this layer can be minimized and an absorption of approximately 50% can be achieved in the first step. The rest of the IR light will be reflected by the underlying highly doped silicon reflector and again absorbed in its maximum of the electromagnetic wave (in this case the maximum of the reflected wave is at λ/4, which is the optical length between absorber and reflector). With this principle, reflection of up to 85% or more of the IR light within a wavelength of 8-14 μm can be achieved. This results in a highly doped silicon reflector which is highly temperature stable compared to the common metal reflector. Therefore, processes like doping activation of sensing the polysilicon layer can follow without destroying the reflector. Additionally, the amount of absorption can be modified with variation of the doping concentration.

Since no back side release or under-etching of silicon is necessary under the above embodiments, a highly controlled gas release processes can be applied, as known from microbolometers, for example, XeF$_2$ or Vapor HF (VHF) microbolometers, giving control in both the vertical and lateral direction.

By decreasing the mass of the thermopile sensor due to the thin absorber, sensing silicon and suspension arms can be made much thinner, providing advantages in terms of thermal conductivity and Seebeck coefficient. As known from nanowires, the Seebeck coefficient increases with structures thinner than, for example, but not limited to, 100 nm.

Another aspect of the absorber is that the sensor membrane can be released directly before capping of the lid, using chip scale packaging techniques. Therefore, destruction of the sensing membrane can be minimized due to handling or further process steps. Overall, the process flow of the above embodiments is aligned with CMOS integration, so that the integration to an array can be realized. For example, embodiments may include an array of pixels.

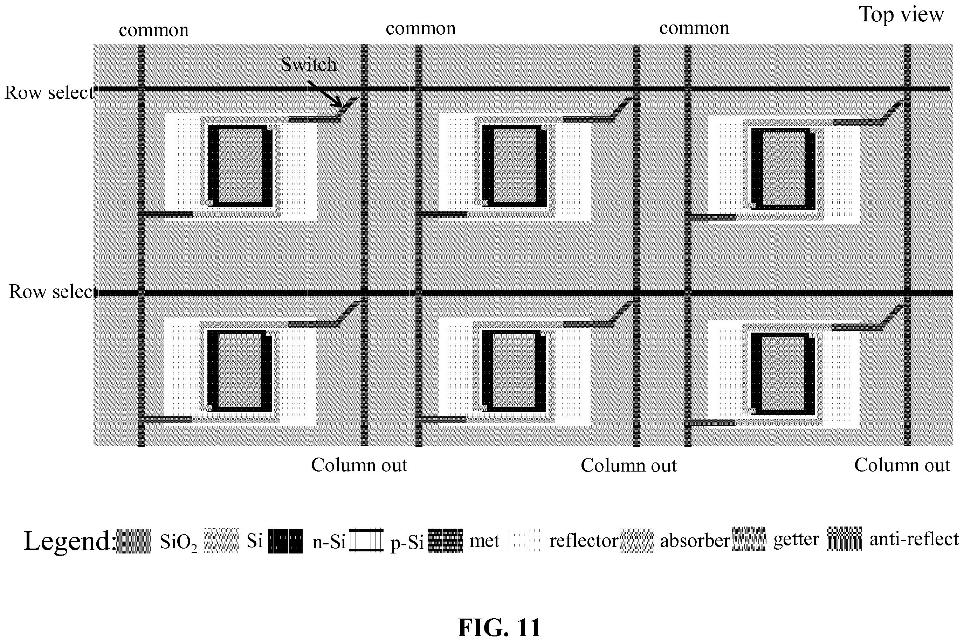

FIG. 11 is a top view schematic diagram of an array integration of resistive microbolometers of FIGS. 9A-9B under a fifth embodiment. The fifth embodiment of a thin film IR sensor may include a CMOS read-out circuit integrated on the same wafer, for example, in an array integration. In such an array a switch may be incorporated to switch a read-out signal of each pixel in a row. This switch and logic can be achieved by using the defined CMOS transistors 210 (FIG. 2) and the metal contact 240 (FIG. 2) to connect these transistors. Similarly, any logic of CMOS is possible with the process flow, such as CMOS transistor logic, thermopile sensor formation, and connection of logic through metal contacts. Of course, other exemplary embodiments are also possible, for example, arrays of thermopiles under the first embodiment, arrays of lateral diode-bolometers under the second embodiment, and arrays of vertical diode-bolometers under the third embodiment. Additionally, arrays of any of these devices may be formed as vacuum packages.

## Claims

1. A method for manufacturing a surface machined thermopile infrared sensor package, comprising the steps of:

   providing a silicon substrate (110) having a front side surface and a back side surface;
   defining a transistor (130) on the substrate front side surface;
   ion implanting within the substrate at the substrate front side surface a highly doped silicon reflector (140) less than 200 nm thick comprising a peak doping concentration after annealing of greater than $10^{20}$/cm$^3$;
   forming a sensor (150) on the substrate front side surface adjacent to the reflector; and

depositing a thin-film absorber (175) upon the sensor,

wherein the thin-film absorber (175) is substantially parallel to the reflector (140) with the sensor (150) disposed there between.

2. The method of claim 1, further comprising the step of releasing the front side surface of the infrared sensor (150).

3. The method of claim 2, wherein the step of releasing the front side surface of the infrared sensor (150) further comprises forming a cavity by etching a spacer (155) between the reflector (140) and the absorber (175).

4. The method of claim 3, wherein said etching is a front side surface etching.

5. The method of any of claims 1, 2, 3 or 4, further comprising the step of vacuum packaging for further miniaturization of the surface machined infrared sensor package.

6. A surface machined thermopile infrared sensor configured to detect a radiation wavelength, comprising:

a silicon wafer (110) having a front side and a back side;
a highly doped silicon reflector (140) less than 200 nm thick comprising a peak doping concentration after annealing of greater than $10^{20}/cm^3$ implanted within a portion of the wafer at the front side surface;
a thin-film interferometric absorber (175) disposed parallel to the reflector; and
a front side infrared sensor (150) disposed between the reflector (140) and the thin-film absorber (175), the front side infrared sensor comprising:

an n-type sensing silicon (160); and
a p-type sensing silicon (165).

7. The sensor of claim 6, wherein the thin-film absorber (175) is impedance matched to atmosphere, and/or the thin-film absorber impedance is on the order of 377 S2/sq.

8. The sensor of claim 6 or 7. wherein the wafer back side does not include a recess behind the sensor (150).

9. The sensor of claims 6, 7, or 8, wherein the thin film interferometric absorber (175) is disposed a quarter wavelength distance from the reflector (140), wherein the wavelength comprises a radiation wavelength detected by the sensor.

10. The sensor of claims 6, 7, 8, or 9, wherein the front side infrared sensor (150) further comprises first and second silicon dioxide layers (120, 125) disposed between the sensor and the reflector (140).

11. The sensor of claim 10, wherein the n-type sensing silicon (160) and/or the p-type sensing silicon (165) is less than 200 nm thick.

12. The sensor of claim 6 or 7 to 11, further comprising a CMOS read-out circuit integrated on the wafer.

13. The sensor of claims 6 to 12, wherein the sensor is at least partially vacuum packaged.

14. A two dimensional array of surface machined infrared sensors according to any of claims 6 to 13.

15. The sensor of claims 6 to 13, wherein the front side infrared sensor (150) further comprises sensing silicon and/or a suspension arm thinner than 200 nm.

**Patentansprüche**

1. Verfahren zum Herstellen eines oberflächenbearbeiteten Thermosäulen-Infrarotsensorpakets, umfassend die folgenden Schritte:

Bereitstellen eines Siliziumsubstrats (110) mit einer Vorderseitenoberfläche und einer Rückseitenoberfläche;
Definieren eines Transistors (130) auf der Vorderseitenoberfläche des Substrats;
Ionenimplantieren, innerhalb des Substrats an der Vorderseitenoberfläche des Substrats, eines hochdotierten Siliziumreflektors (140) mit einer Dicke von weniger als 200 nm, der eine Spitzendotierungskonzentration nach dem Glühen von mehr als $10^{20}/cm^3$ umfasst;
Bilden eines Sensors (150) auf der Vorderseitenoberfläche des Substrats neben dem Reflektor; und
Aufbringen eines Dünnschichtabsorbers (175) auf den Sensor,
wobei der Dünnschichtabsorber (175) im Wesentlichen parallel zum Reflektor (140) verläuft und der Sensor (150) dazwischen angeordnet ist.

2. Verfahren nach Anspruch 1, ferner umfassend den Schritt des Lösens der Vorderseitenoberfläche des Infrarotsensors (150).

3. Verfahren nach Anspruch 2, wobei der Schritt des Lösens der Vorderseitenoberfläche des Infrarotsensors (150) ferner das Bilden eines Hohlraums durch Ätzen eines Abstandshalters (155) zwischen dem Reflektor (140) und dem Absorber (175) umfasst.

4.  Verfahren nach Anspruch 3, wobei das Ätzen ein Vorderseitenoberflächenätzen ist.

5.  Verfahren nach einem der Ansprüche 1, 2, 3 oder 4, ferner umfassend den Schritt des Vakuumverpackens zur weiteren Miniaturisierung des oberflächenbearbeiteten Infrarotsensorpakets.

6.  Oberflächenbearbeiteter Thermosäulen-Infrarotsensor, der zum Erkennen einer Strahlungswellenlänge konfiguriert ist, umfassend:

     einen Siliziumwafer (110) mit einer Vorderseite und einer Rückseite;
     einen hochdotierten Siliziumreflektor (140) mit einer Dicke von weniger als 200 nm, der eine Spitzendotierungskonzentration nach dem Glühen von mehr als $10^{20}$/cm$^3$ umfasst und innerhalb eines Abschnitts des Wafers an der Vorderseitenoberfläche implantiert ist;
     einen interferometrischen Dünnschichtabsorber (175), der parallel zum Reflektor angeordnet ist; und
     einen vorderseitigen Infrarotsensor (150), der zwischen dem Reflektor (140) und dem Dünnschichtabsorber (175) angeordnet ist, wobei der vorderseitige Infrarotsensor umfasst:

          ein Sensorsilizium vom n-Typ (160); und
          ein Sensorsilizium vom p-Typ (165).

7.  Sensor nach Anspruch 6, wobei der Dünnschichtabsorber (175) an die Atmosphäre impedanzangepasst ist und/oder die Impedanz des Dünnschichtabsorbers in der Größenordnung von 377 S2/sq liegt.

8.  Sensor nach Anspruch 6 oder 7, wobei die Waferrückseite keine Aussparung hinter dem Sensor (150) enthält.

9.  Sensor nach Anspruch 6, 7 oder 8, wobei der interferometrische Dünnschichtabsorber (175) in einem Viertelwellenlängenabstand vom Reflektor (140) angeordnet ist, wobei die Wellenlänge eine vom Sensor erfasste Strahlungswellenlänge umfasst.

10. Sensor nach Anspruch 6, 7, 8 oder 9, wobei der vorderseitige Infrarotsensor (150) ferner eine erste und zweite Siliziumdioxidschicht (120, 125) umfasst, die zwischen dem Sensor und dem Reflektor (140) angeordnet sind.

11. Sensor nach Anspruch 10, wobei das Sensorsilizium vom n-Typ (160) und/oder das Sensorsilizium vom p-Typ (165) weniger als 200 nm dick sind.

12. Sensor nach Anspruch 6 oder 7 bis 11, ferner umfassend eine auf dem Wafer integrierte CMOS-Ausleseschaltung.

13. Sensor nach Anspruch 6 bis 12, wobei der Sensor zumindest teilweise vakuumverpackt ist.

14. Zweidimensionale Anordnung von oberflächenbearbeiteten Infrarotsensoren nach einem der Ansprüche 6 bis 13.

15. Sensor nach Anspruch 6 bis 13, wobei der vorderseitige Infrarotsensor (150) ferner Sensorsilizium und/oder einen Aufhängungsarm mit einer Dicke von weniger als 200 nm umfasst.

**Revendications**

1.  Procédé permettant la fabrication d'un boîtier de capteur infrarouge à thermopile à surface usinée, comprenant les étapes de :

     fourniture d'un substrat de silicium (110) comportant une surface de face avant et une surface de face arrière ;
     définition d'un transistor (130) sur la surface de face avant du substrat ;
     l'implantation ionique à l'intérieur du substrat au niveau de la surface avant du substrat d'un réflecteur en silicium hautement dopé (140) d'une épaisseur inférieure à 200 nm comprenant une concentration de dopage maximale après recuit supérieure à $10^{20}$/cm$^3$ ;
     la formation d'un capteur (150) sur la surface de face avant du substrat adjacente au réflecteur ; et
     le dépôt d'un absorbeur à couches minces (175) sur le capteur,
     ledit absorbeur à couches minces (175) étant sensiblement parallèle au réflecteur (140) avec le capteur (150) disposé entre eux.

2.  Procédé selon la revendication 1, comprenant en outre l'étape de libération de la surface de face avant du capteur infrarouge (150).

3.  Procédé selon la revendication 2, ladite étape de libération de la surface de face avant du capteur infrarouge (150) comprenant en outre la formation d'une cavité en gravant une entretoise (155) entre le réflecteur (140) et l'absorbeur (175).

4.  Procédé selon la revendication 3, ladite gravure étant une gravure de surface de face avant.

5.  Procédé selon l'une quelconque des revendications 1, 2, 3 ou 4, comprenant en outre l'étape de conditionnement sous vide pour une miniaturisation supplémentaire du boîtier de capteur infrarouge à surface usinée.

6. Capteur infrarouge à thermopile à surface usinée configuré pour détecter une longueur d'onde de rayonnement, comprenant :

   une tranche de silicium (110) possédant une face avant et une face arrière ;
   un réflecteur en silicium fortement dopé (140) d'une épaisseur inférieure à 200 nm comprenant une concentration de dopage maximale après recuit supérieure à $10^{20}/cm^3$ implanté à l'intérieur d'une partie de la tranche au niveau de la surface de face avant ;
   un absorbeur interférométrique à couches minces (175) disposé parallèlement au réflecteur ; et
   un capteur infrarouge de face avant (150) disposé entre le réflecteur (140) et l'absorbeur à couches minces (175), le capteur infrarouge de face avant comprenant :

      un silicium de détection de type n (160) ; et
      un silicium de détection de type p (165).

7. Capteur selon la revendication 6, ledit absorbeur à couches minces (175) étant adapté en impédance à l'atmosphère, et/ou ladite impédance de l'absorbeur à couches minces étant de l'ordre de 377 S2/carré.

8. Capteur selon la revendication 6 ou 7, ladite face arrière de tranche ne comprenant pas d'évidement derrière le capteur (150).

9. Capteur selon les revendications 6, 7 ou 8, ledit absorbeur interférométrique à couches minces (175) étant disposé à une distance d'un quart de longueur d'onde à partir du réflecteur (140), ladite longueur d'onde comprenant une longueur d'onde de rayonnement détectée par le capteur.

10. Capteur selon les revendications 6, 7, 8 ou 9, ledit capteur infrarouge de face avant (150) comprenant en outre des première et seconde couches de dioxyde de silicium (120, 125) disposées entre le capteur et le réflecteur (140).

11. Capteur selon la revendication 10, ledit silicium de détection de type n (160) et/ou ledit silicium de détection de type p (165) possédant une épaisseur inférieure à 200 nm.

12. Capteur selon la revendication 6 ou 7 à 11, comprenant en outre un circuit de lecture CMOS intégré sur la tranche.

13. Capteur selon les revendications 6 à 12, ledit capteur étant au moins partiellement conditionnée sous vide.

14. Réseau bidimensionnel de capteurs infrarouges à surface usinée selon l'une quelconque des revendications 6 à 13.

15. Capteur selon les revendications 6 à 13, ledit capteur infrarouge de face avant (150) comprenant en outre le silicium de détection et/ou un bras de suspension plus mince que 200 nm.

FIG. 1A

FIG. 1B

FIG. 1C

FIG. 1D

FIG. 1E

FIG. 1F

Legend:
- SiO₂
- Si
- n-Si
- p-Si
- met
- reflector
- absorber
- Passivation

FIG. 2

**FIG. 3**

EP 2 995 916 B1

FIG. 4A

FIG. 4B

FIG. 4C

FIG. 4D

FIG. 4E

FIG. 4F

Legend: SiO₂ | Si | n-Si | p-Si | met | reflector | absorber | Passivation

```
┌─────────────────────────────────────────────────┐
│           Definition of CMOS transistors          │
│                       510                          │
└─────────────────────────────────────────────────┘
                        │
                        ▼
┌─────────────────────────────────────────────────┐
│             Implantation of reflector              │
│                       520                          │
└─────────────────────────────────────────────────┘
                        │
                        ▼
┌─────────────────────────────────────────────────┐
│        Formation of diode-bolometer polysilicon    │
│                       530                          │
└─────────────────────────────────────────────────┘
                        │
                        ▼
┌─────────────────────────────────────────────────┐
│            Thin-film absorber deposition           │
│                       540                          │
└─────────────────────────────────────────────────┘
                        │
                        ▼
┌─────────────────────────────────────────────────┐
│  Deposition of metal contact for diode-bolometer and CMOS │
│                       550                          │
└─────────────────────────────────────────────────┘
                        │
                        ▼
┌─────────────────────────────────────────────────┐
│         Release step & 2nd metal contact           │
│                       560                          │
└─────────────────────────────────────────────────┘
```

500

**FIG. 5**

**FIG. 6A**

600 →

Legend: ▦ SiO₂  ▦ Si  ▮ n-Si  ▥ p-Si  ▤ met  ⋮ reflector  ▦ absorber

EP 2 995 916 B1

600

FIG. 6B

Legend: ▨ SiO₂  ▨ Si  ▨ n-Si  ▨ p-Si  ▨ met  ▨ reflector  ▨ absorber

# FIG. 7A

700

# FIG. 7B

700

Legend: SiO₂  Si  n-Si  p-Si  met  reflector  absorber

FIG. 8A

800

FIG. 8B

800

Legend: ▨ SiO₂  ▨ Si  ▨ n-Si  ▨ p-Si  ▨ met  ▨ reflector  ▨ absorber

EP 2 995 916 B1

EP 2 995 916 B1

**FIG. 9A**

900 →

**FIG. 9B**

900 →

Legend: ▦ SiO₂  ▦ Si  █ Resistive sensing material  ▦ met   reflector ▦ absorber

Legend: ▨ SiO₂ ▨ Si ▨ n-Si ▥ p-Si ▥ met ▤ reflector ▨ absorber ▨ getter ▨ anti-reflect

**FIG. 10**

FIG. 11

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20100031992 A1